Europäisches Patentamt

**European Patent Office**

Office européen des brevets

(11) Publication number: **0 167 299 B1**

## EUROPEAN PATENT SPECIFICATION

(45) Date of publication of patent specification: **06.05.92**

(51) Int. Cl.⁵: **G01R 21/00**, F22B 35/10

(21) Application number: **85303996.4**

(22) Date of filing: **05.06.85**

(54) **Monitoring power usage.**

(30) Priority: **06.07.84 US 628666**

(43) Date of publication of application:
**08.01.86 Bulletin 86/02**

(45) Publication of the grant of the patent:
**06.05.92 Bulletin 92/19**

(84) Designated Contracting States:
**DE FR GB IT**

(56) References cited:
**DE-A- 2 362 230
GB-A- 2 101 340
US-A- 3 522 421
US-A- 4 110 825
US-A- 4 412 136**

**BABCOCK & WILCOX, Engineering Specification G19-1 REV. E, 12/1/73**

**Functional Diagramming of Instruments and Control Systems, Bailey Controls**

(73) Proprietor: **INTERNATIONAL CONTROL AUTO-MATION FINANCE S.A.
16 Rue des Bains
Ville de Luxembourg(LU)**

(72) Inventor: **Scheib, Thomas J.
12865 Woodside Drive
Chesterland Ohio 44026(US)**

(74) Representative: **Cotter, Ivan John et al
D. YOUNG & CO. 10 Staple Inn
London WC1V 7RD(GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

Rank Xerox (UK) Business Services
(–/2.18/2.0)

## Description

This invention relates to the monitoring of power usage. More particularly, but not exclusively, the invention relates to methods of and apparatus for obtaining a correction value relating actual power usage and target power usage during a cycle period.

A "demand charge" billing technique for electricity is a billing technique which charges the user based on facility requirements (kilowatt-hours (kWh) over a particular time period) for plant power rather than the amount of energy actually used. If, for example, the peak power requirement in a given period (which is typically 30 minutes) is 15kW, the electricity generating utility must maintain generating capacity at 15 kW for the plant, whether all this power is actually used or not. A fixed demand window refers to the fact that the demand value is calculated for a given time in sequential time periods, with the largest power requirement then being used for billing purposes. Typically, the demand charge will be between 30% and 80% of the total electricity bill. Therefore, reducing the demand charge is a cost effective approach to reducing energy costs and therefore, for example, overall production costs.

Special purpose electronics and/or computer systems have been utilised to forecast and control purchased power versus generated power. Many of these systems accomplish this objective by a method known as load shedding.

United States Patent No. 3,522,421 discloses a system for monitoring and adjusting the consumption of power in a local industrial site from a power supplier. The difference between the actual rate of power drain and an ideal rate of power drain up to a given point in a demand period is calculated. The amount of power which can be consumed in the time remaining in the demand period after that point is derived, and a corresponding power consumption increase, or load shedding, is effected. Further, US-A-4110825 discloses a system for the same purpose where the overshoot or undershoot with respect to a target energy consumption at the end of the demand period is predicted based on the measured instantaneous rate and this rate adjusted to bring the actual trajectory onto this target.

According to one aspect of the present invention there is provided a method of obtaining a correction value used to modify actual total power usage so as to approach target power usage during a cycle period, the method comprising:

selecting a target power usage for the cycle period;

dividing the cycle period into a plurality of sequential time segments;

determining, after each time segment, a fraction of the cycle period that has elapsed since the beginning of the cycle period;

after each time segment, multiplying the fraction, by the target power usage to obtain a partial target power usage value;

determining, after each time segment, the actual power usage in that segment and adding this value to the actual power usage in any previous time segments to obtain an actual total power usage during the fraction of the cycle period;

obtaining, after each time segment, the difference between the partial target power usage value and the actual total power usage to obtain a difference value;

determining, after each time segment, the time remaining in the cycle period; and

after each time segment, dividing the difference value by the time remaining to obtain the correction value.

According to another aspect of the present invention there is provided apparatus for obtaining a correction value used to modify actual total power usage so as to approach target power usage during a cycle period, the apparatus comprising:

timer means for setting the cycle period at a selected duration;

means to sequentially measure actual power usage in time segments during the cycle period and means to determine the actual total power usage since the beginning of the cycle period from the sum of the actual power usage values in each time segment;

cycle time fraction means connected to the timer means for determining a fraction of cycle period which has elapsed since the beginning of the cycle period;

time remaining means connected to the timer means for determining the time remaining in the cycle period;

calculator means connected to the cycle time fraction means, the time remaining means and the power determining means for calculating the correction value, after each time segment, as a function of the desired target power usage value, the calculator means comprising a multiplier for multiplying the fraction from the cycle time fraction means by the target power usage value to obtain a fraction of the target power usage value utilised from the beginning of the cycle period, means for taking the difference between the fraction of the target power usage value and the determined actual total power usage, and a divider for dividing said difference by the time remaining in the cycle period determined by the time remaining means to obtain the correction value.

According to a preferred embodiment of the present invention described below, a so-called "tieline control" is utilised to stabilize the demand for electricity, and thereby reduce demand peaks and their associated high charges.

According to the preferred method and apparatus for tieline control, a trajectory is first calculated for purchased power. This trajectory, in turn, is utilised to predict a correction required in local or internal generation. When no correction is required, the internal generation is maintained at one operator selected base value. The preferred method can operate with multiple turbine generators and the preferred apparatus can be implemented utilising distributed microprocessor based control equipment. Thus, for the case of internal or local generation, the amount of electricity generated at a plant site is regulated. In applications of the invention where electricity is not generated, load shedding can be utilised as an alternative to regulating local generation.

According to one example of a control arrangement embodying the invention, it is assumed that a turbine is to be regulated to minimise demand and that electricity generated at a plant is more costly than purchased electricity except when a new peak demand charge is set. Having these assumed conditions, the control arrangement regulates the turbine so that purchased power does not exceed the demand limit and so that generated power is held at a minimum. The actual amount of kWh usage for the period is compared to the limit of kWh usage for the same time period. Any difference is then the deviation of power purchased from the desired value. This deviation (or amount of correction required) is divided by the time left within the period to develop a load demand bias to the turbine. By repeating this process several times a second, the target demand continuously compensates for demand changes. Continuously adjusting the target demand causes the actual usage to "home in" on target usage throughout the period.

Since any deviation occurring in the last portion of the period could result in instabilities in the control action on the turbine, the turbine bias is preferably held constant as the time left in a period approaches zero. Also, the bias is preferably held constant during the start of each period to allow data to be gathered for the purpose of establishing a trend.

Various mechanisms can be used to control power consumption. The control effect calculated from the target and actual usage values may be used to adjust extraction flow or steam vent flow of a turbine. Another alternative is to use control efect to provide a rational mechanism to introduce selected load shedding which reduces purchased power. Implementation of a demand limit system must be customised for each individual site and its own economic considerations.

While a fixed demand window (for example the 30 minute period) is generally utilised, a variable window can also be utilised.

The preferred apparatus described hereinbelow is made up of simple function blocks and thus does not require the use of a computer or its associated programming.

The preferred apparatus is simple in design, rugged in construction and economical to manufacture.

The invention will now be further described, by way of illustrative and non-limiting example, with reference to the accompanying drawings, in which:

Figure 1 is a block diagram showing a logic circuit of a preferred apparatus in accordance with an embodiment of the invention, in conjunction with measuring and timing equipment; and

Figure 2 is a block diagram illustrating how a correction value generated by the circuit of Figure 1 can be utilised to control the operation of a turbine for regulating an actual amount of power generated.

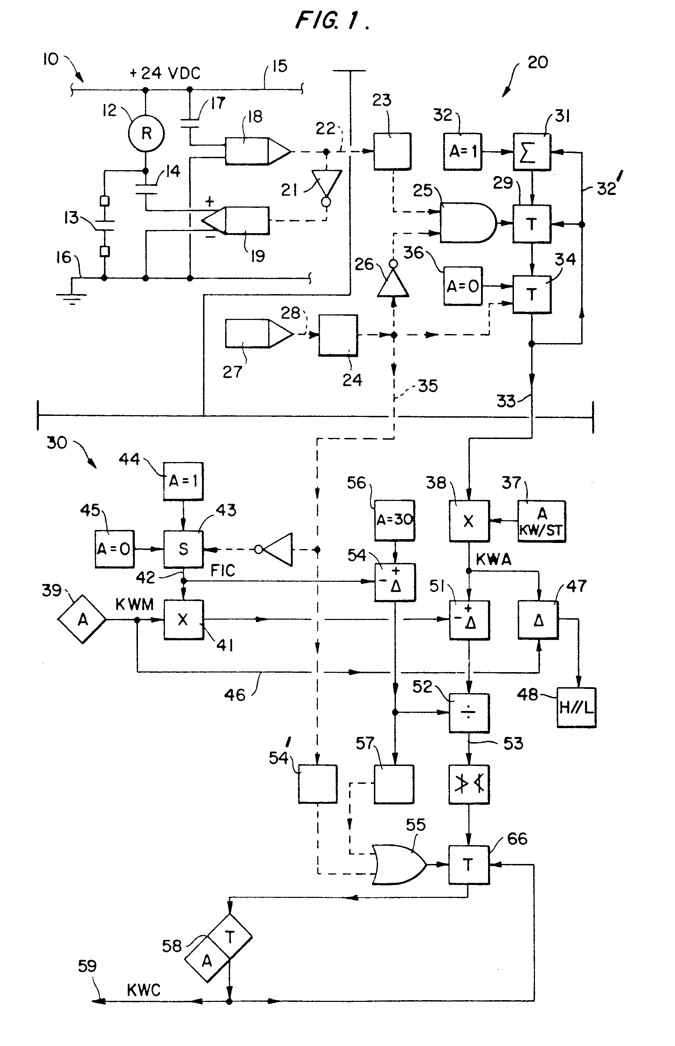

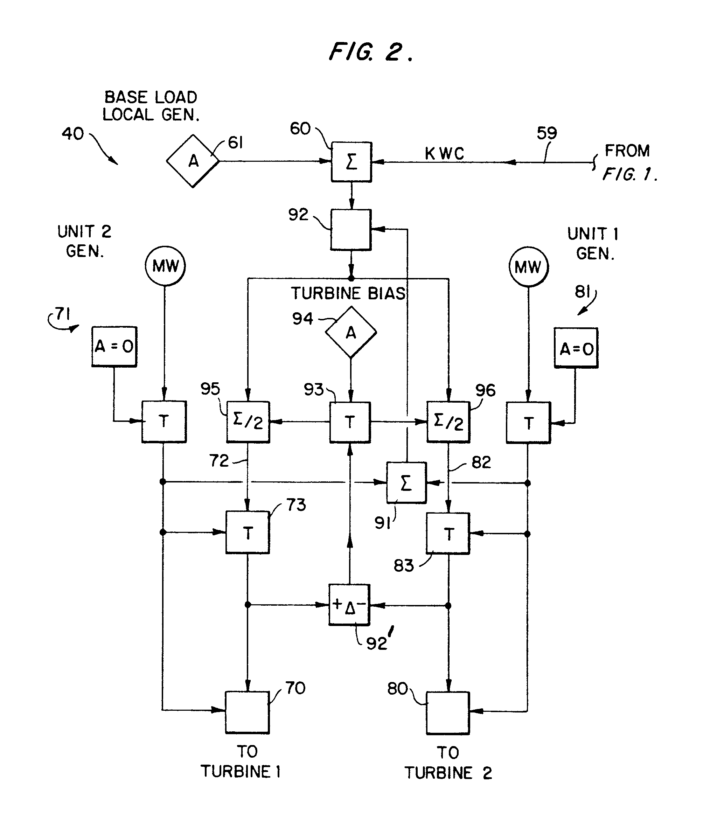

Figure 1 of the drawings shows a tieline control or logic circuit embodying the invention for generating a correction value which compares an actual amount of power usage (energy) to a desired amount of power usage (energy) so that the actual amount can be regulated or other appropriate actions can be taken. The circuit of Figure 1 includes a first section 10 for holding asynchronous pulses on a 24 volt d c line, so that they can be counted in a counting logic circuit section 20. A third section 30 contains a timer and logic for calculating a kW correction or correction value needed to bring actual power usage to a target value for the power usage. The section 30 also includes an alarm which is activated if a deviation between the actual and target usage is too high.

Before discussing Figure 1 in greater detail, it should be noted that the algorithm which is used in the invention is

$$KWC = \frac{(KWM)(FIC) - (KWA)}{(CT) - (TIC)}$$

where KWC is the power correction value, KWM is the maximum or target energy usage value in kWh (kilowatt-hours), FIC is the fraction of time into each cycle, that is the fraction of the time elapsed in each cycle, KWA is the power usage or energy (kWh) which has been used or accumulated during each cycle, CT is the total cycle time or cycle period which is in general 30 minutes, and TIC is the time which has elapsed into the cycle.

The numerator of the algorithm thus calculates the fractional amount of the target energy or power usage value and subtracts from this the actual amount of energy used up to that point in the cycle. The denominator represents the time remaining in the cycle. The cycle period of generally 30 minutes is divided into a plurality of time segments which are generally fractions of a second, and the power correction value is calculated after each time segment. As noted above, the correction value is artificially held constant during the beginning and ending portions of the time cycle to avoid instability at these times.

Turning once more to Figure 1, the input section 10 includes a relay 12 which is connected in series with an external input pulse contact 13 between a 24 volt d c line 15 and a ground line 16. The pulse contact 13 is for the energy (kWh) purchased. A sealed in contact 14 latches the relay 12 in the energised state when the contact 13 is pulsed. A sealed in contact 17 is connected in series with a logic unit 18 between the 24 V d c line 15 and the ground line 16. The logic unit 19 is connected in a Boolean circuit with an inverter 21. (Boolean logic lines are shown as dotted lines while solid lines indicate the passage of an analog signal). The output of the circuit section 10 is a line 22 on which there are developed pulses which correspond to the amount of energy (kWh) actually being used at any point in time.

The circuit section 20 includes two signal scalers 23 and 24. The signal sealer 23 provides pulses from the line 22 to an input of an AND-gate 25. Another input of the AND-gate 25 is connected via an inverter 26 to an output of the signal scaler 24. The scaler 24 receives an input from a timer 27 which impresses a reset pulse on a line 28 at the end of each cycle period. Such a pulse is thus generated every 30 minutes, for example. Upon the generation of this pulse, the inverter 26 inverts the pulse (which is a high pulse) to a low signal at the output of inverter 26 so the output of the AND-gate 25 is inhibited.

An output of the AND-gate 25 is connected to a transfer block 29 which receives an input from a summing unit 31. The summing unit 31 receives a constant initial input from a constant generator 32 and also is connected over a feedback line 32' to an output line 33 of a second transfer block 34. The second transfer block 34 is connected to a line 35 which is connected to the output of the signal scaler 24. The second transfer block 34 also receives an initial zeroing value from a constant element 36. In this way, the number of counts is returned to zero on the line 33 after the end of each full cycle.

A constant element 37 in the circuit section 30 is connected to a multiplier 38 which also receives a number of counts measured from the beginning of each cycle on the line 33. The constant element 37 carries a scaling value which indicates the energy (kWh) per count so that the output of the multiplier 38 represents the energy accumulated from the beginning of each cycle, namely the factor KWA in the above-mentioned algorithm.

The desired maximum power usage KWM is provided at an input 39 to a further multiplier 41 where the desired value is multiplied by the fraction of time (FIC) into each cycle from a line 42. The value FIC is measured in a timer 43 which receives an inverted input from the line 35 for resetting the timer to zero at the beginning of each cycle, and initial values from a constant element 44. The timer 43 can be reset manually by a constant element 45 which impresses a zero value in the timer 43.

The input element 39 is also connected over a line 46 to a comparator 47 which receives another input (the value KWA) from the multiplier 38.

In this way, the actual power usage can be compared to the total desired power usage or target power usage after each time segment. If this value represents a difference which is too high, this is sensed by a limiting element 48 which is used as an alarm.

A comparator 51 receives a negative input from the multiplier 41 which represents the fraction of the desired energy or power usage (kWh) accumulated, that is the fraction (KWM.FIC) of the energy used so far in the cycle, and receives a positive input from the multiplier 38 representing the total amount of energy (KWA) used or accumulated thus far in the cycle. A signal on an output of the comparator 51 represents the present deviation between desired value (KWM.FIC) and the actual value (KWA) of the energy (kWh) so far consumed. A divider 52 is utilised to divide this deviation by the time remaining in the cycle to obtain the kWh correction value KWC on a line 53.

The time remaining in the cycle (CT-TIC) is obtained by a comparator 54, which is connected to a constant element 56 which contains a value corresponding to the cycle time (CT) of 30 minutes, and which has a negative input connected to the line 42 on which is present the signal FIC representing the time into the cycle.

The calculated correction value KWC is held constant during the first and last portions of each cycle period by a timer 54' which is connected via an OR-gate 55 to a transfer block 66. The transfer block 66 is instructed to hold the last correction value if it receives a high signal from the OR-gate 55. The OR-gate 55 generates a high signal during the first ten minutes of each cycle by means of the timer 54' and during the last ten minutes of each cycle by means of a low value limiting element 57 which has an input connected to the comparator 54 and an output connected to another input of the OR-gate 55. The output of the transfer block 66 is connected to a regulating device 58 which outputs a usable signal (KWC) on a line 59.

As shown in Figure 2, a circuit 40 is connected to the line 59 and, as indicated above, converts the correction value KWC into a bias signal which can be used to regulate one or more turbines driving respective generators and thus modify the amount of power being generated.

The line 59 is connected to a summing element 60 which receives an initial setting from an input element 61 corresponding to a base load for local power generation.

Two control elements 70 and 80 for two turbines can be regulated in accordance with the correction value KWC. They receive a local control signal from respective circuits 71 and 81 and a remote controlling signal on lines 72 and 82 connected to transfer blocks 73 and 83, respectively. The total output of the two turbines is measured and summed in a summing unit 91 which has an output connected to a comparator 92. The comparator 92 has another input connected to the summing unit 60 which receives the correction value FWC. To maintain a balanced usage of the two generators, a comparator 92' is connected between outputs of the transfer blocks 73 and 83 and feeds a signal back to a further transfer block 93 which also has a turbine bias value provided thereto by an input unit 94. The transfer block 93 outputs values to comparators 95 and 96 which modify the signals on the lines 72 and 82, respectively.

## Claims

1. A method of obtaining a correction value (KWC) used to modify actual total power usage so as to approach a target power usage during a cycle period (CT), the method comprising:

    selecting a target power usage (KWM) for the cycle period (CT);

    dividing the cycle period (CT) into a plurality of sequential time segments;

    determining, after each time segment, a fraction of the cycle period (FIC) that has elapsed since the beginning of the cycle period (CT);

    after each time segment, multiplying the fraction (FIC), by the target power usage (KWM) to obtain a partial target power usage value (KWM.FIC);

    determining, after each time segment, the actual power usage in that segment and adding this value to the actual power usage in any previous time segments to obtain an actual total power usage (KWA) during the fraction (FIC) of the cycle period (CT);

    obtaining, after each time segment, the difference between the partial target power usage value (KWM.FIC) and the actual total power usage (KWA) to obtain a difference value (KWM.FIC-KWA)

    determining, after each time segment, the time (CT-TIC) remaining in the cycle period (CT); and

    after each time segment, dividing the difference value (KWM.FIC-KWA) by the time remaining (CT-TIC) to obtain the correction value (KWC).

2. A method according to claim 1, wherein actual total power usage (KWA) comprises power used from a primary power source and, after each time segment, the correction value (KWC) is used as a signal to regulate a controllable power generator (UNIT 1 GEN.; UNIT 2 GEN.) of a secondary power source, and the actual total power usage (KWA) from the primary power source is modified to approach the target power usage (KWM).

3. A method according to claim 1, wherein the correction value (KWC) is used to cause load shedding so that the actual total power usage (KWA) is modified to approach the target power usage (KWM).

4. A method according to claim 1, claim 2, or claim 3 wherein the cycle period (CT) is divided into beginning, middle and end time portions and in which the correction value (KWC) is held constant during the beginning and end time portions.

5. A method according to anyone of the preceding claims wherein the actual total power usage (KWA) is compared, after each time segment, with the target power usage (KWM) and if the comparison is a value above a preset threshold, an alert (48) is made.

6. Apparatus for obtaining a correction value (KWC) used to modify actual total power usage (KWA) so as to approach a target power usage (KWM) during a cycle period (CT), the apparatus comprising:

    timer means (27) for setting the cycle period (CT) at a selected duration;

means (10, 20) to sequentially measure actual power usage in time segments during the cycle period (CT) and means (29, 37, 38) to determine the actual total power usage (KWA) since the beginning of the cycle period (CT) from the sum of the actual power usage values in each time segment;

cycle time fraction means (43) connected to the timer means (27) for determining a fraction (FIC) of cycle period (CT) which has elapsed since the beginning of the cycle period (CT);

time remaining means (54) connected to the timer means (27) for determining the time (CT-TIC) remaining in the cycle period (CT);

calculator means (41, 51, 52) connected to the cycle time fraction means (43), the time remaining means (54) and the power determining means (29, 37, 38) for calculating the correction value (KWC), after each time segment, as a function of the desired target power usage value (KWM), the calculator means (41, 51, 52) comprising a multiplier (41) for multiplying the fraction (FIC) from the cycle time fraction means (43) by the target power usage value (KWM) to obtain a fraction (KWM.FIC) of the target power usage value (KWM) utilised from the beginning of the cycle period (CT), means (51) for taking the difference between the fraction (KWM.FIC) of the target power usage value (KWM) and the determined actual total power usage (KWA), and a divider (52) for dividing said difference by the time (CT-TIC) remaining in the cycle period (CT) determined by the time remaining means (54) to obtain the correction value (KWC).

7. Apparatus according to claim 6, in which the actual total power usage (KWA) comprises power used from a primary power source and a signal generating means in response to the correction value (KWC) generates a signal to regulate a controllable power generator (UNIT 1 GEN. UNIT 2 GEN.) in a secondary power source to modify the actual total power usage (KWA) from the primary power source so as to approach the target power usage (KWM).

8. Apparatus according to claim 6, in which a signal generating means in response to the correction value (KWC) generates a signal to activate load shedding circuitry so that the actual total power usage (KWA) is modified to approach the target power usage (KWM).

9. Apparatus according to claim 6, claim 7, or claim 8 in which, after each time segment, a comparator (47) compares the actual total power usage (KWA) with the target power usage (KWM) and if the comparison is a value above a preset threshold an alert signal is generated by an alert (48).

10. Apparatus according to any one of claims 6 to 9, including holding means (54', 55, 57, 66) to hold the correction value (KWC) constant during time portions at the beginning and end of the cycle period (CT).

## Revendications

1. Procédé d'obtention d'une valeur de correction utilisée pour modifier la consommation de courant totale réelle de manière à se rapprocher de la consommation de courant cible pendant une période de cycle (CT), le procédé comprenant :

la sélection d'une consommation de courant cible pour la période de cycle (CT) ;

la division de la période de cycle (CT) en une pluralité de segments de temps séquentiels ;

la détermination, après chaque segment de temps, d'une fraction de la période de cycle (FIC) qui s'est écoulée depuis le commencement de la période de cycle (CT) ;

après chaque segment de temps, la multiplication de la fraction (FIC), par la consommation de courant cible (KWM) pour obtenir une valeur de consommation de courant cible partielle (KWM.FIC) ;

la détermination, après chaque segment de temps, de la consommation de courant réelle dans ce segment et l'addition de cette valeur à la consommation de courant réelle dans tous les segments de temps antérieurs pour obtenir une consommation de courant totale réelle (KWA) pendant la fraction (FIC) de la période de cycle (CT) ;

l'obtention, après chaque segment de temps, de la différence entre la valeur de consommation de courant cible partielle (KWM.FIC) et la consommation de courant totale réelle (KWA) pour obtenir une valeur de différence (KWM.FIC - KWA) ;

la détermination, après chaque segment de temps, du temps restant (CT - TIC) dans la période de cycle (CT) ; et

après chaque segment de temps, la division de la valeur de la différence (KWM.FIC - KWA) par le temps restant (CT - TIC) pour obtenir la valeur de correction (KWC).

2. Procédé selon la revendication 1, dans lequel la consommation de courant totale réelle (KWA) comprend le courant utilisé à partir d'une source de courant primaire, et après chaque segment de temps, la valeur de correction (KWC) est utilisée comme signal pour réguler une génératrice de courant commandable (UNIT 1 GEN. ; UNIT 2 GEN.) d'une source de courant secondaire, et la consommation de courant totale réelle (KWA) issue de la source de courant primaire est modifiée pour s'approcher de la consommation de courant cible (KWM).

3. Procédé selon la revendication 1, dans lequel la valeur de correction (KWC) est utilisée pour provoquer un délestage de charges de sorte que la consommation de courant totale réelle (KWA) soit modifiée pour s'approcher de la consommation de courant cible (KWM).

4. Procédé selon la revendication 1, la revendication 2 ou la revendication 3, dans lequel la période de cycle (CT) est divisée en des parties de temps de commencement, de milieu et de fin et dans lequel la valeur de correction (KWC) est maintenue constante pendant les parties de temps de commencement et de fin.

5. Procédé selon l'une quelconque des revendications précédentes, dans lequel la consommation de courant totale réelle (KWA) est comparée après chaque segment de temps, avec la consommation de courant cible (KWM) et si la comparaison est une valeur au dessus d'un seuil prédéterminé, une alarme (48) est donnée.

6. Appareil pour obtenir une valeur de correction utilisé pour modifier la consommation de courant totale (KWA) de manière se rapprocher de la consommation de courant cible (KWM) pendant une période de cycle (CT), l'appareil comprenant :
un moyen d'horloge (27) pour fixer la période de cycle (CT) à une durée choisie ;
un moyen (10, 20) pour mesurer de manière séquentielle l'utilisation de courant dans des segments de temps pendant la période de cycle (CT) et un moyen (29, 37, 38) pour déterminer la consommation de courant totale réelle (KWA) depuis le commencement de la période de cycle (CT) à partir de la somme des valeurs de consommation de courant réelles dans chaque segment de temps ;
un moyen (43) de fractionnement de la période de cycle connecté au moyen d'horloge (27) pour déterminer une fraction (FIC) de la période de cycle (CT) qui s'est écoulé depuis le commencement de la période de cycle (CT) ;

un moyen (54) de détermination du temps restant connecté au moyen d'horloge (27) pour déterminer le temps restant (CT - TIC) dans la période de cycle (CT) ;
un moyen de calculateur (41, 51, 52) connecté au moyen de fractionnement (43) de la période de cycle, au moyen (54) de détermination du temps restant et au moyen (29, 37, 38) de détermination du courant pour calculer la valeur de correction (KWC), après chaque segment de temps, en fonction de la valeur de consommation de courant cible (KWM) souhaitée, le moyen de calculateur (41, 51, 52) comprenant un multiplieur (41) pour multiplier la fraction (FIC) issue du moyen de fractionnement (43) de la période de cycle par la valeur de consommation de courant cible (KWM) pour obtenir une fraction (KWM.FIC) de la valeur de consommation de courant cible (KWM) utilisée à partir du début de la période de cycle (CT), un moyen (51) pour prendre la différence entre la fraction (KWM.FIC) de la valeur de consommation de courant cible (KWM) et la valeur de consommation totale réelle (KWA) déterminée, et un diviseur (52) pour diviser ladite différence par le temps restant (CT - TIC) dans la période de cycle (CT) déterminée par le moyen de détermination du temps restant (54) pour obtenir la valeur de correction (KWC).

7. Appareil selon la revendication 6, dans lequel la consommation de courant totale réelle (KWA) comprend le courant utilisé à partir d'une source de courant primaire et dans lequel un moyen de production de signal en réponse à la valeur de correction (KWC) produit un signal pour réguler une génératrice de courant commandable (UNIT 1 GEN. ; UNIT 2 GEN.) dans une source de courant secondaire pour modifier la consommation de courant totale (KWA) à partir de la source de courant primaire de manière à approcher la consommation de courant cible (KWM).

8. Appareil selon la revendication 6, dans lequel un moyen de production de signal en réponse à la valeur de correction (KWC) produit un signal pour activer des circuits de délestage de charges de sorte que la consommation de courant totale (KWA) est modifiée pour approcher la consommation de courant cible (KWM).

9. Appareil selon la revendication 6, la revendication 7 ou la revendication 8, dans lequel, après chaque segment de temps, un comparateur (47) compare la consommation de courant totale réelle (KWA) avec la consommation de courant cible (KWM) et si la comparaison est une valeur au dessus d'un seuil prédéterminé un signal d'alarme est produit par une alarme (48).

10. Appareil selon l'une quelconque des revendications 6 à 9, comprenant des moyens de maintien (54', 55, 57, 66) pour maintenir la valeur de correction (KWC) constante pendant des parties de temps au commencement et à la fin de la période de cycle (CT).

**Patentansprüche**

1. Verfahren zum Erhalten eines Korrekturwertes (KWC), welcher üblicherweise verwendet wird, um den momentanen Gesamtenergieverbrauch zu verändern, um sich einem angestrebten Energieverbrauch während eines Zyklusabschnittes (CT) anzunähern, wobei das Verfahren aufweist:
Auswählen eines angestrebten Energieverbrauchs (KWM) für den Zyklusabschnitt (CT), Aufteilen des Zyklusabschnittes (CT) in eine Mehrzahl aufeinanderfolgender Zeitsegmente, Bestimmen eines Bruchteiles des Zyklusabschnittes (FIC), welcher seit dem Beginn des Zyklusabschnittes (CT) vorüber ist, und zwar nach jedem Zeitsegment,
Multiplizieren des Bruchteiles (FIC) nach jedem Zeitsegment mit dem angestrebten Energieverbrauch (KWM), um einen Wert für den teilweisen Energieverbrauch (KWM . FIC) zu erhalten,
Bestimmen des momentanen Energieverbrauchs in dem Segment nach jedem Zeitsegment und Hinzufügen dieses Wertes zu dem jeweiligen Energieverbrauch in jedem der vorangehenden Zeitsegmente, um einen momentanen Gesamtenergieverbrauch (KWA) während des Bruchteiles (FIC) des Zyklusabschnittes (CT) zu erhalten,
Erfassen des Unterschiedes zwischen dem teilweise angestrebten Energieverbrauchswert (KWM . FIC) und dem momentanen totalen Energieverbrauchs (KWA) nach jedem Zeitsegment, um einen Differenzwert (KWM . FIC - KWA) zu erhalten,
Bestimmen der Zeit (CT - TIC), welche in dem Zyklusabschnitt (CT) verbleibt und zwar nach jedem Zeitsegment, und
Dividieren des Differenzwertes (KWM . FIC-KWA) durch die verbleibende Zeit (CT-TIC), nach jedem Zeitsegment, um den Korrekturwert (KWC) zu erhalten.

2. Verfahren nach Anspruch 1, wobei der momentane Gesamtenergieverbrauch (KWA) die aus einer primären Energiequelle verbrauchte Energie enthält, und wobei nach jedem Zeitsegment der Korrekturwert (KWC) als ein Signal verwendet wird, um einen regelbaren Energieerzeuger (UNIT 1 GEN.; UNIT 2 GEN.) einer sekundären Energiequelle zu regeln, und wobei der momentane Gesamtenergieverbrauch (KWA) aus der primären Energiequelle verändert wird, um sich dem angestrebten Energieverbrauch (KWM) anzunähern.

3. Verfahren nach Anspruch 1, wobei der Korrekturwert (KWC) verwendet wird, um einen Lastabwurf zu bewirken, so daß der momentane Gesamtenergieverbrauch (KWA) verändert wird, um eine Annäherung an den angestrebten Energieverbrauch (KWM) zu erhalten.

4. Verfahren nach Anspruch 1, 2 oder 3, wobei der Zyklusabschnitt (CT) in einen Anfangs-, Mittel- und Endabschnitt aufgeteilt wird und wobei der Korrekturwert (KWC) während des Anfangs- und des Endabschnittes konstant gehalten wird.

5. Verfahren nach einem der vorstehenden Ansprüche, wobei der momentane Gesamtenergieverbrauch (KWA) nach jedem Zeitsegment mit dem angestrebten Energieverbrauch (KWM) verglichen wird und, falls der Vergleich einen Wert oberhalb eines vorher festgesetzten Grenzwertes ergibt, ein Warnsignal (48) abgegeben wird.

6. Vorrichtung zum Erhalten eines Korrekturwertes (KWC), der verwendet wird, um den momentanen Gesamtenergieverbrauch (KWA) zu verändern, um sich einem angestrebten Energieverbrauch (KWM) während eines Zyklusabschnitts (CT) anzunähern, wobei die Vorrichtung aufweist:
eine Zeitgebereinrichtung (27), um den Zyklusabschnitt auf eine ausgewählte Zeitdauer festzusetzen,
eine Einrichtung (10, 20), um aufeinanderfolgend den momentanen Energieverbrauch in Zeitabschnitten während des Zyklusabschnittes (CT) zu messen, und
eine Einrichtung (29, 37, 38), um den momentanen Gesamtenergieverbrauch (KWA) seit dem Beginn des Zyklusabschnittes (CT) aus der Summe der momentanen Energieverbrauchswerte in jedem Zeitsegment zu bestimmen,
eine Bruchteileinrichtung (43) für die Zykluszeit, welche mit der Zeitgebereinrichtung (27) verbunden ist, um einen Bruchteil (FIC) eines Zyklusabschnittes (CT) zu bestimmen, der seit Beginn des Zyklusabschnittes (CT) vergangen ist,

eine Einrichtung (24) für verbleibende Zeit, welche mit der Zeitgebereinrichtung (27) verbunden ist, um die Zeit (CT-TIC) zu bestimmen, welche in dem Zyklusabschnitt (CT) verbleibt,

eine Berechnungseinrichtung (41, 51, 52), welche mit der Bruchteileinrichtung (43) für die Zykluszeit, der Einrichtung (54) für die verbleibende Zeit und der Energiebestimmungseinrichtung (29, 37, 38) verbunden ist für die Berechnung des Korrekturwertes (KWC), nach jedem Zeitsegment, als Funktion des gewünschten, angestrebten Energieverbrauchswertes (KWM), wobei die Berechnungseinrichtung (41, 51, 52) einen Multiplizierer (41) zum Multiplizieren des Bruchteiles (FIC) aus der Bruchteileinrichtung (43) für die Zykluszeit mit dem angestrebten Energieverbrauchswert (KWM) aufweist, um einen Bruchteil (KWM FIC) des angestrebten Energieverbrauchswertes (KWM) zu erhalten, der seit Beginn des Zyklusabschnittes (CT) verbraucht wurde, eine Einrichtung (51) aufweist, um die Differenz zwischen dem Bruchteil (KWM. FIC) des angestrebten Energieverbrauchswertes (KWM) und des festgestellten momentanen Gesamtenergieverbrauchs (KWA) anzunehmen, und einen Dividierer (52) aufweist, um diese Differenz durch die Zeit (CT-TIC) zu dividieren, die in dem Zyklusabschnitt (CT) verbleibt, welcher durch die Einrichtung (54) für verbleibende Zeit festgestellt wurde, um den Korrekturwert (KWC) zu erhalten.

7. Vorrichtung nach Anspruch 6, bei welcher der momentane Gesamtenergieverbrauch (KWA) Energie aus einer primären Energiequelle enthält und wobei eine Signalerzeugungseinrichtung unter Ansprechen auf den Korrekturwert (KWC) ein Signal erzeugt, um einen regelbaren Energieerzeuger (UNIT 1 GEN. UNIT 2 GEN.) in einer sekundären Energiequelle zu regeln, um den momentanen Gesamtenergieverbrauch (KWA) aus der primären Energiequelle zu modifizieren, um sich so dem angestrebten Energieverbrauch (KWM) anzunäheren.

8. Vorrichtung nach Anspruch 6, bei welcher eine Signalerzeugungseinrichtung unter Ansprechen auf den Korrekturwert (KWC) ein Signal erzeugt, um einen Lastabwurfschaltkreis zu aktivieren, so daß der momentane Gesamtenergieverbrauch (KWA) so modifiziert wird, daß er sich dem angestrebten Energieverbrauch (KWM) annähert.

9. Vorrichtung nach Anspruch 6, 7 oder 8, bei welcher nach jedem Zeitsegment ein Komparator (47) den aktuellen Gesamtenergieverbrauch (KWA) mit dem angestrebten Energieverbrauch (KWM) vergleicht und, falls der Vergleich einen Wert ergibt, der oberhalb eines zuvor festgesetzten Grenzwertes liegt, ein Warnsignal durch eine Vorwarneinrichtung (48) erzeugt wird.

10. Vorrichtung nach einem der Ansprüche 6 bis 9, einschließlich einer Halteeinrichtung (54', 55, 57, 66), um den Korrekturwert (KWC) während der Zeitabschnitte zu Beginn und am Ende des Zyklusabschnittes (CT) konstant zu halten.

## FIG. 1.

FIG. 2.